Europäisches Patentamt

European Patent Office

Office européen des brevets

(11) Publication number: **0 421 343 A2**

(12) **EUROPEAN PATENT APPLICATION**

(21) Application number: 90118860.7

(22) Date of filing: 02.10.90

(51) Int. Cl.5: **H01L 23/552**

(30) Priority: 03.10.89 JP 259203/89

(43) Date of publication of application:
10.04.91 Bulletin 91/15

(84) Designated Contracting States:
DE FR GB

(71) Applicant: **MATSUSHITA ELECTRIC INDUSTRIAL CO., LTD.**
**1006, Oaza Kadoma**
**Kadoma-shi, Osaka-fu, 571(JP)**

(72) Inventor: **Makino, Yutaka**
**4-6-48-316 Sumiyoshiyamate, Higashinada-ku**
**Kobe-shi, Hyogo-ken(JP)**
Inventor: **Ishimoto, Kazumi**
5-10-17, Fujigao
Katano-shi, Osaka-fu(JP)
Inventor: **Izumi, Yasuo**
2-4-21, Motomachi
Ikoma-shi, Nara-ken(JP)
Inventor: **Kitayama, Yoshifumi**
1-15-6-202 Higashinakaburi
Hirakata-shi, Osaka-fu(JP)
Inventor: **Kumagai, Koichi**
1658-535, Kitatawara-cho
Ikoma-shi, Nara-ken(JP)

(74) Representative: **Eisenführ, Speiser & Strasse**
**Martinistrasse 24**
**W-2800 Bremen 1(DE)**

(54) Semiconductor element package and semiconductor element package mounting distributing circuit basic plate.

(57) A semiconductor element package and a semiconductor element package mounting distributing circuit basic plate, wherein the shield metallic layer is provided on the flexible insulating basic plate for constituting the package, so that the semiconductor element mounted on the flexible insulating basic plate may be kept electromagnetically shielded positively with the shield metallic layer, whereby troublesome operation such as mounting the bulk high box shaped electromagnetic shield member on the outside of the semiconductor element package mounted on the distributing circuit basic plate as in the conventional one is not required, and, also, since the shield metallic layer is provided on the face, which is not formed with the lead patterns, of the flexible insulating basic plate, no influences are applied at all upon the construction of the land pattern and the mounting construction of the semiconductor element.

*Fig. 1 (a)*

## SEMICONDUCTOR ELEMENT PACKAGE AND SEMICONDUCTOR ELEMENT PACKAGE MOUNTING DIS-TRIBUTING CIRCUIT BASIC PLATE

### BACKGROUND OF THE INVENTION

The present invention generally relates to a semiconductor element package and a semiconductor element package mounting distributing circuit basic plate, and more particularly, to a semiconductor element package for mounting semiconductor chips such as IC, LSI and so on so as to simplify the handling, and the mounting onto the distributing circuit and so on, and a distributing circuit basic plate with such semiconductor element packages being mounted thereon.

In order to mount the semiconductor elements on the distributing circuit plates so as to build in them in various types of electronic apparatuses for the employment thereof, it is required that the noises and the ill influences should not be applied which are caused through the electromagnetic waves caused by the adjacent electronic parts and the electric circuits or the external surroundings. Also, something has to be done to prevent the electromagnetic waves, which are caused by the semiconductor elements themselves, from applying the ill influences upon the surrounding circuits and the electromagnetic components. Namely, the semiconductor elements are required to be electromagnetically shielded against the surrounding surroundings.

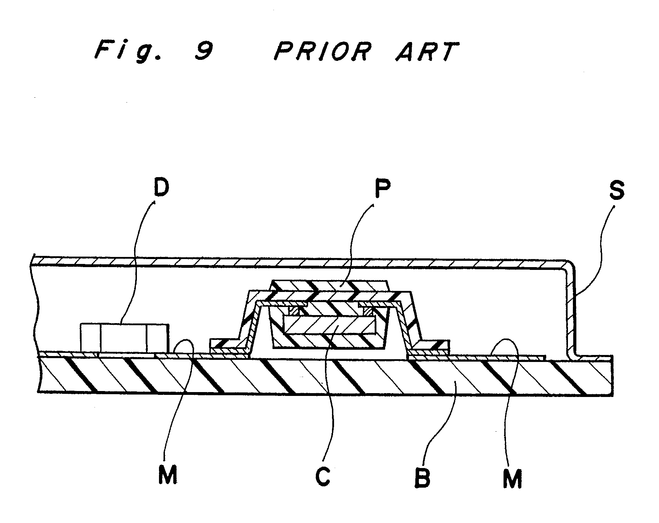

Conventionally such electromagnetic shield construction as shown in Fig. 9 was adopted. Namely, the semiconductor element package P with the semiconductor element C accommodated therein is fixedly mounted on the distributing circuit basic plate B, and is electrically connected with the distributing circuit M. Electric elements D such as resistors, capacitors and so on are mounted on and connected with the distributing circuit M. A box-shaped electromagnetic shield member S composed of metallic sheet plate and so on is mounted so as to cover the whole surfaces including the semiconductor element package mounted location of such a distributing circuit basic plate B. The electromagnetic shield member S is adapted to cut off the influences caused by the electromagnetic waves from the external surroundings, and also, to prevent the electromagnetic waves, which are caused by the semiconductor element C, the distributing circuit M and so on, from being externally leaked.

Such electromagnetic shield member as described hereinabove is so high in bulk that the space for mounting the semiconductor package mounting distributing circuit basic plate is required to be wider, with a disadvantage that the size of the whole electronic apparatus with the the basic plates being built in in it becomes larger. The manufacturing cost of the electromagnetic shield member becomes also higher. The mounting operation of the electromagnetic shield member by the covering the distributing circuit basic plate takes more time, with a troublesome problem that the electromagnetic shield members have to be removed one by one in the examination of the distributing circuit, and so on.

### SUMMARY OF THE INVENTION

Accordingly, the present invention has been developed with a view to substantially eliminating the above discussed drawbacks inherent in the prior art, and has for its essential object to provide an improved semiconductor element package and a semiconductor element package mounting distributing circuit basic plate.

Another important object of the present invention is to provide an improved semiconductor element package and semiconductor element package mounting distributing circuit basic plate, which are capable of keeping the semiconductor elements positively shielded electromagnetically without the use of the electromagnetic shield member having such many problems as described hereinabove.

In accomplishing these and other objects, according to the claim 1 of the present invention, there is provided a semiconductor element package, wherein the semiconductor element is mounted, with the lead patterns being formed, on the single face of a flexible insulating basic plate, each electrode of the semiconductor element is electrically connected with the lead pattern, and which is characterized in that shield metallic layer for electromagnetic shield use is formed on the face, opposite to the lead pattern forming face, of the above described flexible insulating basic plate.

As the basic construction of the semiconductor element package, there is applied as it is the construction generally called a film flat pack type package. Namely, a semiconductor element electrode outgoing lead pattern composed of conductive metals such as Cu and so on is formed on the single face of the flexible insulating basic plate composed of polymide resin film an so on. The semiconductor element is fixedly mounted in the center of the flexible insulating basic plate. Each electrode of the semiconductor element is connected with the respective lead patterns. The connection of the semiconductor element electrodes with the lead patterns may be either the construction of the bonding wire connection or the construction of the direct connection of the semiconductor element electrode through bumps onto the lead patterns. The semiconductor element mounting location and its vicinity is covered with sealing resin such as epoxide resin and so on, so that the semiconductor element and the connecting locations between the semiconductor element and the lead patterns are protected. The external peripheral portions of the lead patterns are exposed to the external portion of the sealing resin so as to achieve the connection with the external circuits of the distributing circuit basic plates and so on.

Since the semiconductor element electrode outgoing lead patterns formed on the single face of the flexible insulating basic plate are connected facing the external circuits of the distributing circuit basic plate and so on, the semiconductor element mounted on the face the same as the face of the lead patterns is arranged between the flexible insulating basic plate and the distributing circuit basic plate and so on.

In this invention, in the semiconductor element package provided with such basic construction as described hereinabove, a shield metallic layer for electromagnetic shield use which is capable of cutting off the passing of the electromagnetic waves is formed on the face, on the side opposite to the face with the lead patterns being formed on it, of the flexible insulating basic plate. The shield metallic layer which is a sheet metal layer of metal superior in electromagnetic wave cutting off property such as Cu, Ni, Al, Fe and so on. The metallic leaf is bonded on the flexible insulating plate or it is formed on the surface of the flexible insulating basic plate by the sheet membrane forming art of plating, evapolating and so on. Although the shield metallic layer is most preferable to be kept formed on the whole face of the flexible insulating basic plate, the shield metallic layer is not necessary to be formed if the locations are not necessary to the electromagnetic shield of the semiconductor element.

The metal which constitutes the shield metallic layer may be a material the same as the metal of the above described lead pattern, and be a different material. When the shield metallic layer and the lead pattern are composed of the same material, it is required to keep the masking operation effected so that the shield metallic layer may not be etched in the pattern etching of the lead pattern after the metallic layer has been formed on both the faces of the flexible insulating basic plate.

In the invention described in accordance with the claim 2, the lead patterns and the shield metallic layer are made of different types of metallic material in the semiconductor element package described in accordance with the above described claim 1.

Namely, by the use of such a material as metal different from a material of the lead pattern, and as not be etched by the etching liquid of the lead pattern as the material of the shield metallic layer, the masking of the shield metallic layer may be made unnecessary at the pattern etching time. For example, if the shield metallic layer is kept as Ni layer when the lead pattern is formed of Cu layer, and ammonium persulfate is used as the etching liquid of the Cu layer, the masking of the shield metallic layer becomes unnecessary, because the Ni layer is not etched by the antimony persulfate. The same thing can be said if the Ni layer is laminated on the Cu layer as the shield metallic layer. When the metal is likely to be etched by the etching liquid of the lead pattern, the masking is required even if the shield metallic layer and the lead pattern are different different in material.

In the invention described in accordance with the claim 3, the shield metallic layer is electrically connected with the land portion formed on the lead pattern forming side of the flexible insulating basic plate through a through hole extending through the flexible insulating basic plate in the semiconductor element package described in accordance with the claim 1.

The land portion is formed in a position different from the semiconductor element electrode outgoing lead pattern, and is adapted to be connected, with the land portion facing the external circuit in the mounting of the semiconductor element package on the distributing circuit basic plate and so on. The land portion may be one location, or may be a plurality of locations. The concrete shape and the construction of the land portion and the through hole are similar to those of the normal circuit basic plate and so on.

The semiconductor element package mounting distributing circuit basic plate described in accordance with the claim 4 is a distributing circuit basic plate with the semiconductor element package described in accordance with the claim 1 being mounted on it, and the shield metallic layer is formed on the basic plate surface in the locations not covered with the shield metallic layer of the semiconductor element package.

As the basic construction of the distributing circuit basic plate, there can be applied the construction of the normal distribution circuit basic plate which is built in in various types of electronic apparatuses and is used. The distributing circuits formed on the single face of one basic plate or on both the faces thereof may be used freely as the distributing circuit basic plate, or multiple layer circuit plates with insulating layers and distributing circuits of a plurality of layers being laminated may be freely used. The semiconductor element packages are fixedly mounted on the surface of the distributing circuit basic plate, the respective lead patterns are connected with the land portions connecting the distributing circuit on the distribution circuit basic plate surface or the distributing circuit of the inner layer.

In order to cut off the electromagnetic waves passing through the gaps of the semiconductor element packages themselves, the shield metallic layer is formed onto the surface of the distributing circuit basic plate of the surface of the distributing circuit basic plate. The shield metallic layer is composed of the same material as the shield metallic layer of the above described semiconductor element package, the shield metallic layer has only to be formed on the all the locations not covered with the shield metallic layer of the semiconductor element package or only on the location where the electromagnetic waves are required to be cut off from passing. If the shield metallic layer of the distributing circuit basic plate and the shield metallic layer of the semiconductor element package are electrically connected with the wire bonding and so on, the electromagnetic shielding effect is all the more improved.

When the semiconductor element packages are arranged and mounted on the same surface of the distributing circuit basic plate, the semiconductor element packages are required to be mounted avoiding the distributing circuit forming locations of the distributing circuit basic plate surfaces. When the land portions for mounting, connecting the semiconductor element packages are provided on the surfaces of the multiple layer distributing circuit basic plate so as to connect the land portions with the inner layer distributing circuit, the distributing circuit is not exposed onto the distributing circuit basic plate surface, so that the semiconductor element packages may be freely arranged, thus improving the mounting efficiency of the semiconductor element packages. Also, since the setting interval between the semiconductor element packages may be narrowed, the electromagnetic waves may be prevented from passing through the gaps of the semiconductor element packages themselves.

The invention described in accordance with the claim 5 is a distributing circuit basic plate with the semiconductor element packages described in the claim 1 being mounted on it, the shield metallic layer of the semiconductor element packages is connected with the earth circuit formed on the distributing circuit basic plate.

The earth circuit is a similar circuit to be formed on the normal distributing circuit basic plate and so on. The shield metallic layer of the semiconductor element package is connected with one portion of the earth circuit. The normal distributing connecting means such as wire bonding, through hole connection and so on may be adopted as the connecting method. Also, when a plurality of semiconductor element packages are mounted on the surface of the distributing circuit basic plate, the shield metallic layers themselves of the respective semiconductor elements are electrically connected with the wire bonding and so on, with one portion thereof having only to be connected with the earth circuit of the distributing circuit basic plate.

In the invention described in accordance with the claim 6, the earth circuit is an inner layer circuit provided within the basic plate interior of the distributing circuit basic plate, with the shield metallic layer being connected with it through the through hole.

The so-called multiple layer distributing circuit basic plate is used as the distributing circuit basic plate, one portion of the inner layer circuit is used as the earth circuit. In order to connect the shield metallic layer of the distributing circuit basic plate with the inner layer earth circuit, the so-called through hole which is adopted for the connection between the layers in the normal multiple layer distributing circuit basic plate. In the through hole, a hole is drilled through the insulating layer of the distributing circuit basic plate, a conductive metallic layer is formed with the plating or the like in the interior of the through hole so as to connect the distributing circuit on both the faces of the through holes.

In order to connect the shield metallic layer of the semiconductor element package with the inner layer earth circuit of the distributing circuit basic plate, it is more preferable to use the semiconductor element package of the invention described in the above described claim 3 although the shield metallic layer of the semiconductor element package may be connected with the shield metallic layer of the distributing circuit basic surface with the wire boding and so on. Namely, the semiconductor element package is used, where the land portion is provided in the position different from the electrode outgoing lead pattern of the semiconductor element on the face opposite to the flexible insulating basic plate with respect to the shield metallic layer formed on the single face of the flexible insulating basic plate, the above described land portion is connected with the shield metallic layer by the through hole extending through the flexible insulation basic plate. The above described land portion which is disposed on the reverse face of the semiconductor element package at the mounting time onto tho distributing circuit basic plate is directly connected, opposite to the land portion connecting the earth circuit of the distributing circuit basic plate or the shield metallic layer. The shield metallic layer of the distributing circuit basic plate, and the land portion are connected with the inner layer earth circuit provided in the inner layer of the multiple distributing circuit basic plate with the through hole.

According to the invention described in accordance with the claim 1, as the semiconductor element package itself is provided with the shield metallic layer, such metallic box shaped electromagnetic shield member as conventional becomes unnecessary. As the shield metallic layer is integrally formed in advance on the flexible insulating basic plate, the manufacturing operation is easy to effect. Since the shield metallic layer is formed on the face, opposite to the lead pattern, of the flexible insulating basic plate, no influences are applied at all upon the construction of the lead pattern, the mounting construction of the semiconductor element. Since the shield metallic layer is good in the radiation property, there is a function of properly radiating the heat within the semiconductor element package from the surface of the shield metallic layer.

According to the invention described in the accordance with the claim 2, the shield metallic layer is formed with the metallic material of the type different from the lead pattern, so that a step of masking the shield metallic layer on the reverse face may be removed at the etching forming operation of the lead pattern. Also, since the semiconductor element electrode outgoing lead pattern and the shield metallic layer are different in the respective necessary functions, the metallic materials suitable for the respective objects may be used through the choice.

According to the invention described in accordance with the claim 3, by the use of the land portion formed on the same face as the semiconductor element electrode outgoing lead pattern opposite to the external circuit at the mounting time of the semiconductor element package on the distributing circuit basic plate and so on, the shield metallic layer may be directly connected with the earth circuit of the external portion, the connection between the shield metallic layer and the external earth circuit becomes easier, and the mounting operation of the semiconductor element package is also simplified.

According to the invention described in accordance with the claim 4, since the semiconductor element package provided with the shield metallic layer described in accordance with the claim 1 is mounted on the surface of the distributing circuit basic plate, and the shield metallic layer is not provided even on the basic plate surface of the location which is not covered with the shield metallic layer of the semiconductor element package, the whole surfaces of the distributing circuit basic plate is covered with the shield metallic layer, so that the electromagnetic waves may be cut off with the whole faces of the distributing circuit basic plate, thus improving the electromagnetic shield efficiency.

According to the invention described in accordance with the claim 5, as the electromagnetic waves which try to pass through the shield metallic later are adapted to be all flowed into the earth circuit and are removed, the electromagnetic shield effect of the shield metallic layer is all the more improved.

According the invention described in accordance with the claim 6, as the earth circuit is formed in the inner layer of the distributing circuit basic plate, and the inner layer earth circuit and the shield metallic layer of the basic plate surface are connected in the through hole, the set up space for the earth circuit and the wide space for connecting the earth circuit with the shield metallic layer are not necessary to be set up on the basic plate surface. As a result, it is possible to mutually bring into closer contact the distributing circuit to be formed on the surface of the distribution circuit basic plate and the shield metallic layer or the semiconductor element packages to be mounted on the basic plate surface and so on so as to arrange them into higher density.

BRIEF DESCRIPTION OF THE DRAWINGS

These and other objects and feature of the present invention will become apparent from the following embodiment thereof with reference to the accompanying drawings, in which;

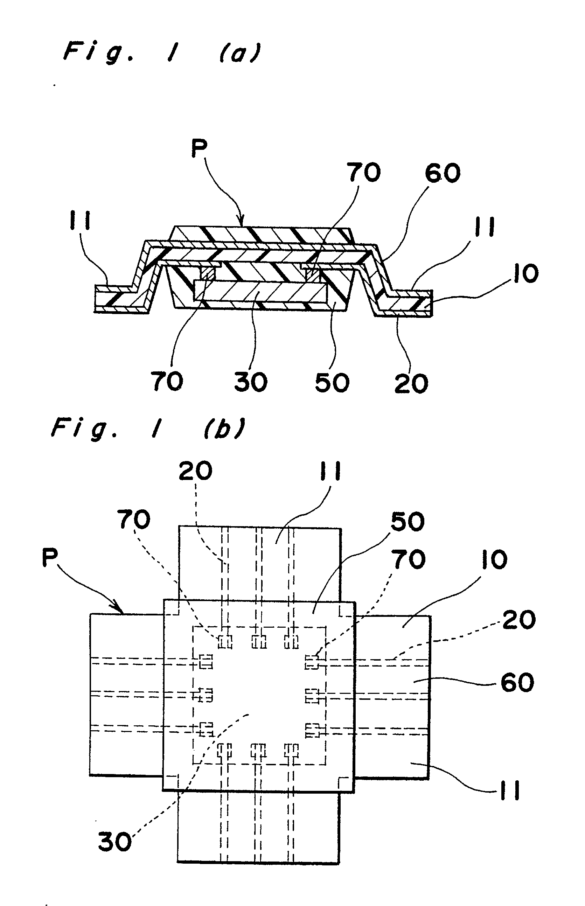

Fig. 1 (a), (b) show a semiconductor element package in one embodiment of the invention;
Fig. 1 (a) is a sectional view thereof;
Fig. 1 (b) is a plan view thereof;
Fig. 2 (a), (b) show another embodiment of a semiconductor element package of the invention;

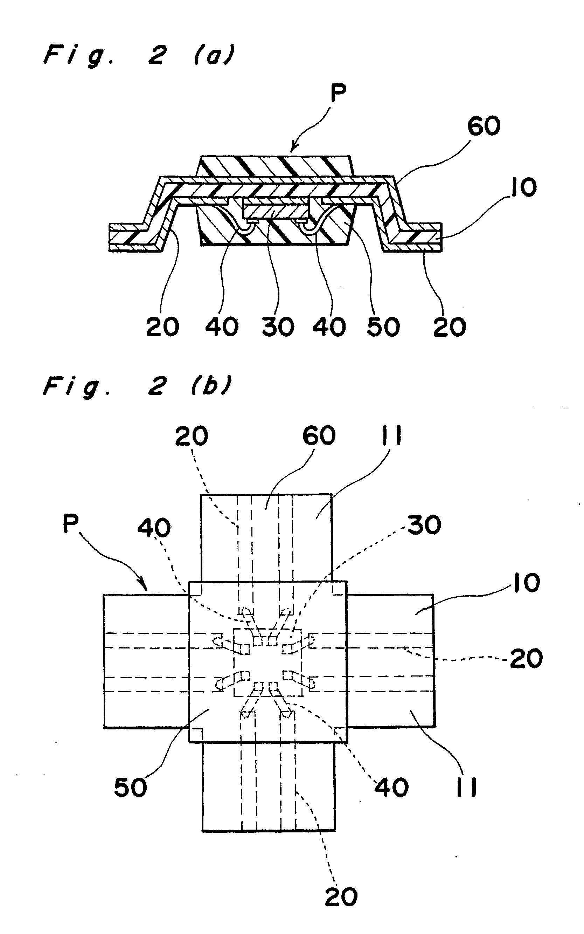

Fig. 2 (a) is a sectional view thereof;
Fig. 2 (b) is a plan view thereof;

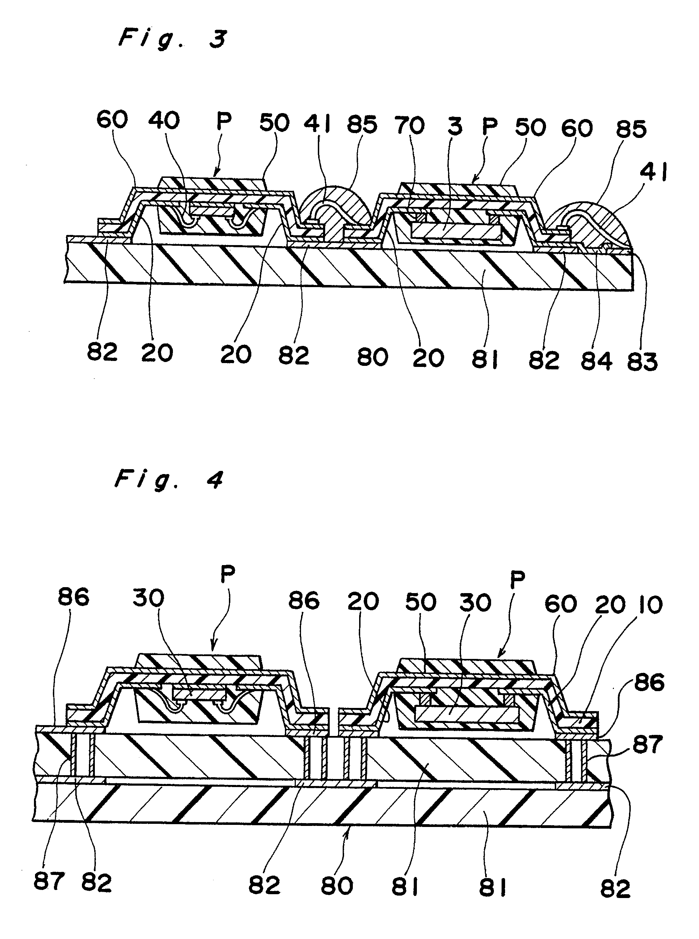

Fig. 3 is a sectional view showing an embodiment of a semiconductor element package mounting distributing circuit basic plate of the invention;
Fig. 4 through Fig. 6 are sectional views each showing different embodiment of the invention;

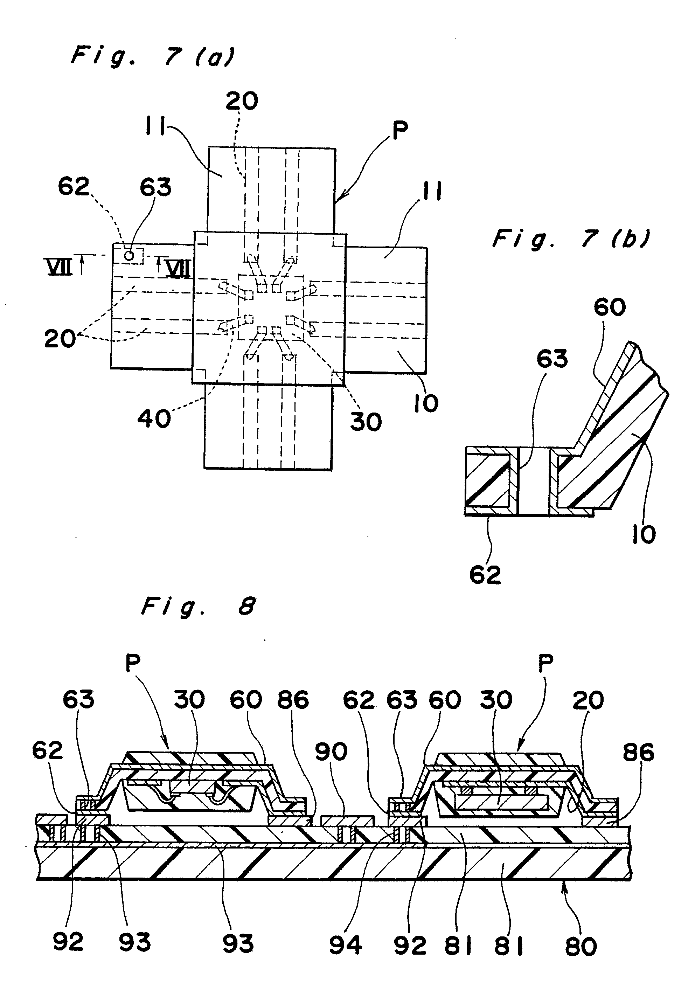

Fig. 7 (a), (b) show a different embodiment of a semiconductor element package of the invention;
Fig. 7 (a) is a plan view of the semiconductor element package of the invention;
Fig. 7 (b) is an enlarged sectional view taken along a line VII - VII of the previous drawing;
Fig. 8 is a sectional view of the distributing circuit basic plate with the semiconductor element package of Fig. 7 being mounted; and
Fig. 9 is a sectional view in the conventional embodiment.

## DETAILED DESCRIPTION OF THE INVENTION

Before the description of the present invention proceeds, it is to be noted that like parts are designated by like reference numerals throughout the accompanying drawings.

Referring now to the drawings, Fig. 1 shows a package of bump construction. A flexible insulating basic plate 10 made of polymide resin film is provided with foot shaped portions 11 projected in four directions from the central portion with a semiconductor element 30 being mounted on it, with the plane shape thereof being approximately cross-shaped. The Cu leaf is laminated on the single face of the flexible insulating basic plate 10 and the leaf patterns 20 are provided by the pattern formation from the Cu leaf. The form pattern of the lead pattern 20 is shown on Fig. 1 (b). The lead pattern 20 has respectively lead patterns 20 with respect to a plurality of patterns of the semiconductor element 30. The external peripheral portion of the lead pattern 20 is formed so far as the tip end of the foot shaped portion 11 of the flexible insulating basic plate 10.

A shield metallic layer 60 composed of Ni layer across the whole face is formed on the face opposite to the formed face of the lead pattern 20 of the flexible insulating basic plate 10.

The semiconductor element 30 is mounted with respect to such flexible insulating basic plate 10, with the electrode of the semiconductor element 30 being spliced through a bump 70 on the central side end portion of the lead pattern 20 of the flexible insulating basic plate 10. The normal bumping materials such as Au, Ni and so on are used for the bump 70. The bumping connection is effected in various types of methods in the normal mounting art. For example, a method of effecting the heating operation is carried out while the flexible insulating basic plate 10 and the semiconductor element 30 are being pressed on each other.

The periphery of the semiconductor element 30 fixedly mounted on the flexible insulating basic plate 10 is covered with sealing resin 50 composed of epoxide resin, so that the semiconductor element 30 is sealed. The foot shaped portion 11 in four directions of the flexible insulating basic plate 10 is exposed without being covered with the sealing resin 50. As shown in the drawing, the exposed foot shaped portion 11 is bent downwards outside the sealing resin 50 and further the tip end thereof is bent so as to be directed in the horizontal direction. The horizontal end of the foot shaped portion 11 is connected with the distributing circuit of the distributing circuit basic plate, and so on.

As the semiconductor element package P of such construction as described hereinabove is mounted on the distributing circuit basic plate with a posture shown in Fig. 1 (a), the semiconductor element 30 is adapted to be suspended from the reverse face of the flexible insulating basic plate 10, so that the shield metallic layer 60 of the flexible insulating basic plate 10 is adapted to completely cover the semiconductor element 30 from above to the sides thereof. Therefore, the electromagnetic waves from the external surroundings are positively cut off with the shield metallic layer 60 of the flexible insulating basic plate 10, so that no influences are adapted to be applied upon the semiconductor element 30. Also, the shield metallic layer 60 positively prevents the electromagnetic waves, which are generated by the semiconductor element 30, from being externally leaked.

Fig. 2 shows a package of wire bonding construction. As the basic construction is the same as that of the embodiment of the above described Fig. 1, the difference between them will be chiefly described hereinabove.

The lead pattern 10 formed on the flexible insulating basic plate 10 is not formed on the central side as far as the under face portion of the semiconductor element 30, but is formed till slightly outside of the outer periphery of the semiconductor element 30. The semiconductor element 30 is fixedly mounted on the central portion of the flexible insulating basic plate 10 with the welding bonding or the like. The electrodes disposed on the surface side of the semiconductor element 30 and the inner end portions of the lead patterns 20 are connected with the use of bonding wires 40 made of thinner wires of conductive metal such as Au, Cu or the like. The sealing resin 50 is formed so as to cover the bonding wires 40. Since the construction is completely the same as that of the above described embodiment except for the differences in the connection construction between the semiconductor element 30 and the lead pattern 10, the description thereof will be described.

Fig. 3 shows the construction of the semiconductor element package mounting distributing circuit basic plate with such a semiconductor element package P as described hereinabove being mounted on the distributing circuit basic plate.

The distributing circuit basic plate 80 has a distributing circuit 82, which is made of conductive metal such as Cu or the like, formed on the surface of the insulating layer 81 made of glass fiber strengthened resin, ceramic or the like, and is basically the same in construction as the conventional normal distributing circuit basic plate.

In the given position of the distributing circuit basic plate 80, the lead pattern 20 end portion of the semiconductor element package P is spliced with the distributing circuit 82, so that the electric connection is achieved and also, the semiconductor element package P is secured onto the distributing circuit basic plate 80. The shield metallic layers 60 of a plurality of semiconductor element packages P are electrically connected with the bonding wires 41, and also, one portion of the shield metallic layer 60 is electrically connected with the earth circuit 83 provided on the distributing circuit basic plate 80 with the bonding wires 41. The earth circuit 83 and the distributing circuit 82 are positively separated insulatingly in the insulating portion 84, and the connecting location by the bonding wire 41 is covered, protected with protective materials 85 of resin or the like.

The embodiment shown in Fig. 4 is different from the embodiment of the above described Fig. 3, in the construction of the distributing circuit basic plate 80. The distributing circuit basic plate 80 is provided with the construction of the multiple layer circuit basic plate laminated with a distributing circuit 82 being grasped between two insulating layers 81. The lead pattern 20 of the semiconductor element package P is spliced with the land portion 86 on the surface of the distributing circuit basic plate 80, and also, the land portion 86 is connected with the inner layer distributing circuit 82 through the through holes 87 extending through the insulating layer 81.

Only the land portion 86 is formed on the surface of the distributing circuit basic plate 80 in this manner, and the space for mounting the semiconductor element package P may be freely provided on the surface of the distributing circuit basic plate 80 unless the distributing circuit 82 is exposed. Namely, if the semiconductor element package P tries to be mounted, avoiding the forming location of the distributing circuit 82 on the surface of the distributing circuit basic plate 80, the mounting location is restricted, so that the interval between the semiconductor element packages P themselves becomes wider. Thus, the electromagnetic waves penetrate onto the side of the distributing circuit basic plate 80 through the gaps of the semiconductor element packages P themselves, so that the electromagnetic waves generated on the side of the distributing circuit basic plate 80 are easier to externally go. As the semiconductor element packages P themselves may be mounted in closer contact on the surface of the distributing circuit basic plate 80 if the distributing circuit 82 is formed in the inner layer as in the embodiment, the gaps between the semiconductor element packages P themselves are removed to prevent the electromagnetic waves from passing through them, so that the electromagnetic shield effect is improved. Also, as the mounting efficiency of the semiconductor element package P is improved and the forming density of the distributing circuit 82 is also improved, the distributing circuit basic plate 80 may be made smaller in size and higher in density.

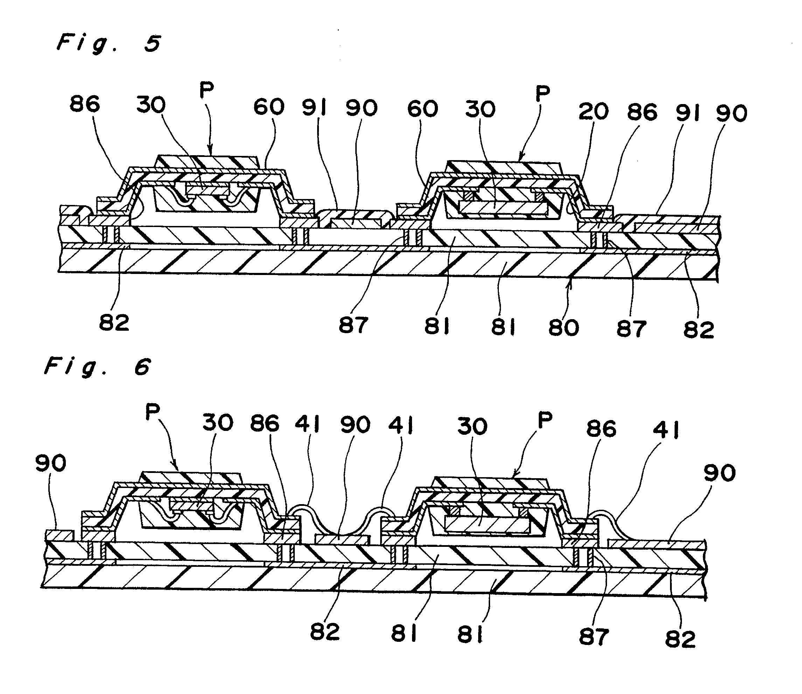

In the embodiment shown in Fig. 5, the shield metallic layer 90 is formed not only on the semiconductor element package P, but also even on the surface of the distributing circuit basic plate 80. As in the above described embodiment, the land portion 86 is provided on the surface of the distributing circuit basic plate 80, and the semiconductor element package P is mounted on, connected with the land portion 86.

In the embodiment, the shield metallic layer 90 in addition to the land portion 86 is formed on the surface of the distributing circuit basic plate 80. The shield metallic layer 90 is formed to cover the whole surfaces of the distributing circuit basic plate 80 which the shield metallic layer 60 of the semiconductor element package P cannot cover, with the semiconductor element package P being mounted on the land portion 86. The shield metallic layer 90 is covered, protected with the protective material 91 such as resin or the like.

If the whole surfaces of the distributing circuit basic plate 80 are covered with either the shield metallic layer 60 or the shield metallic layer 90, the electromagnetic waves may be positively prevented from passing through the distributing circuit basic plate 80

The embodiment shown in Fig. 6 is partially changed in the construction of the embodiment of the above described Fig. 5. Namely, the shield metallic layer 90 on the surface of the distributing surface basic plate 80 and the shield metallic layer 60 of the semiconductor element package P are sequentially connected electrically with the bonding wires, and are connected in its one end with the earth circuit (not shown).

When the shield metallic layers 60, 90 are wholly connected integrally with each other and are earthed in this manner, the electromagnetic shield effect becomes higher.

The embodiment shown in Fig. 7 and Fig. 8 is different from the embodiment of the above described Fig. 6 in the earth connection method of the shield metallic layer 90 of the distributing circuit basic plate 80 and the semiconductor element package P.

As shown in Fig. 7, a land portion 62 for connecting the shield metallic layer 60, in addition to the lead pattern 20, is formed on the forming face of the lead pattern 20 near the tip end of the foot shaped portion 11 of the flexible insulating basic plate 10 of the semiconductor element package P. The land portion 62 is electrically connected with the shield metallic layer 60 with a through hole 63 extending through the flexible insulating basic plate 10.

Fig. 8 shows a condition where the semiconductor element package P of such construction as described hereinabove is mounted on the distributing circuit basic plate 80, the connecting land portion 92 is formed in a position, corresponding to the land portion 62 of the semiconductor element package P, of the surface of the distributing circuit basic plate 80, and also, the electric connection is effected from the land portion 92 to the earth circuit 93 of the inner layer grasped between the insulating layers 81 and 81 through the through hole 94 extending through the insulating layer 81. The shield metallic layer 90 similar to the above description is formed in the location, not covered with the shield metallic layer 60 of the semiconductor element package P, of the surface of the distributing circuit basic plate 80, and the shield metallic layer 90 is also connected with the inner layer earth circuit 93 through the through hole 94. The lead pattern 20 connected the each electrode of the semiconductor element 30 of the semiconductor element package P is connected with the land portion 86 for the distributing circuit use on the surface of the distributing circuit basic plate 80, and is connected with the distributing circuit (not shown) formed on the surface of the distributing circuit basic plate 80 or on the inner layer of the multiple distributing circuit basic plate.

In the case of the above described embodiment, as compared with the embodiment of the above described Fig. 6, the connecting operation with the bonding wires is not required, thus improving the operationality, and also, the connecting performance. Also, the interval between the semiconductor element package P themselves or the interval between the semiconductor element package P and the shield metallic layer 90 of the distributing circuit basic plate 80 is extremely narrow, with the gaps through which the electromagnetic waves leak being hardly seen.

As is clear from the foregoing description, according to the semiconductor element package described in accordance with the claim 1 of the present invention, the shield metallic layer is provided on the flexible insulating basic plate for constituting the package, so that the semiconductor element mounted on the flexible insulating basic plate may be kept electromagnetically shielded positively with the shield metallic layer. Therefore, such troublesome operation as mount the bulk high box shaped electromagnetic shield member on the outside of the semiconductor element package mounted on the distributing circuit basic plate as in the conventional embodiment is not required. Since the shield metallic layer is provided on the face, which is not formed with the lead patterns, of the flexible insulating basic plate, no influences are applied at all upon the construction of the land pattern and the mounting construction of the semiconductor element. As the shield metallic layer is extremely thin, and is formed on the surface of the flexible insulating basic plate, the whole semiconductor element package is not increased in size, is not made complicated in the manufacturing, thus being extremely lower even in the manufacturing cost. As the surface of the flexible insulating basic plate is adapted to be covered with the shield metallic layer superior in radiation property, the heat to be caused from the semiconductor element and so on may be radiated properly, with an effect that the radiating performance of the whole semiconductor element package may be improved.

According to the semiconductor element package described in accordance with the claim 2, as the masking operation of the shield metallic layer does not have to be effected when the lead patterns of the flexible insulating basic plate are formed through the etching, the flexible insulating basic plate with the shield metallic layer attached into it may be manufactured with ease and lower price, so that the semiconductor element package higher in the shield property may be provided with ease and lower price. Also, as the shield metallic layer, the material higher in the electromagnetic shield effect which is different from the lead pattern material may be used through the free choice, so that the shield property of the semiconductor element package may be improved.

According to the semiconductor element package described in accordance with the claim 3, as the electric connection between the shield metallic layer and the earth circuit may be achieved simply by the direct connection of the land portion with the earth circuit of the external portion, the mounting operation of the semiconductor element package, especially the earth connecting operation of the shield metallic layer may be easily effected.

According to the semiconductor element package mounting distributing circuit basic plate described in accordance with the claim 4, as the semiconductor element package described in the claim 1 which is provided with the shield metallic layer is mounted, and also, the shield metallic layer is provided even on the distributing circuit basic plate, it becomes possible to exhibit the positive electromagnetic shield effect across the whole face of the distributing circuit basic plate. Therefore, it is possible to exhibit the superior electromagnetic shield effect even with respect to the various types of electronic components and the electric circuits disposed above and below the distributing circuit basic plate, in addition to the semiconductor element mounted on the distributing circuit basic plate.

According to the semiconductor element package mounting distributing circuit basic plate described in accordance with the claim 5, the electromagnetic shield effect is further improved with the shield metallic layer for achieving the electromagnetic shield function being kept earthed.

According to the semiconductor element package mounting distributing circuit basic plate described in accordance with the claim 6, the forming space of the earth circuit and the space for the connection between the earth circuit and the shield metallic layer are hardly required on the surfaces of the distributing circuit basic plate, and the semiconductor element package and the shield metallic layer may be disposed without almost all the gaps in extremely closer contact, so that the mounting density of the semiconductor element package becomes higher and the distributing circuit basic plate may be made higher in density and smaller in size.

Although the present invention has been fully described by way of example with reference to the accompanying drawings, it is to be noted here that various changes and modifications will be apparent to those skilled in the art. Therefore, unless otherwise such changes and modifications depart from the scope of the present invention, they should be construed as included therein.

## Claims

(1) A semiconductor element package, wherein a semiconductor element is mounted with lead patterns being formed on the single face of a flexible insulating basic plate, each electrode of the semiconductor element is electrically connected with the lead patterns, characterized in that the shield metallic layer for electromagnetic shield use is formed on the face, opposite to the lead pattern forming face, of the above described flexible insulating basic plate.

(2) A semiconductor element package described in accordance with the claim 1, wherein the lead patterns and the shield metallic layer are made of metallic materials different in type.

(3) A semiconductor element package described in accordance with the claim 1, wherein the shield metallic layer is electrically connected with the land portion formed on the face of the lead pattern forming side of the flexible insulating basic plate through a through hole extending through the flexible insulating basic plate.

(4) A semiconductor element package mounting distributing circuit basic plate, which is a distributing circuit basic plate with the semiconductor element package described in accordance with the claim 1 being mounted on it, wherein the shield metallic layer is provided on the basic plate surface in the locations not covered with the shield metallic layer of the semiconductor element package.

(5) A semiconductor element package mounting distributing circuit basic plate, which is a distributing circuit basic plate with the semiconductor element package described in accordance with the claim 1 being mounted on it, wherein the shield metallic layer of the semiconductor element package is connected with the earth circuit formed on the distributing circuit basic plate.

(6) A semiconductor element package mounting distributing circuit basic plate described in accordance with the claim 5, wherein the earth circuit is an inner layer circuit provided within the basic plate interior of the distributing circuit basic plate, with the shield metallic layer being connected with it through the through hole.

Fig. 1 (a)

Fig. 1 (b)

*Fig. 2 (a)*

*Fig. 2 (b)*

11

Fig. 3

Fig. 4

Fig. 5

Fig. 6

Fig. 7 (a)

Fig. 7 (b)

Fig. 8

14

## Fig. 9   PRIOR ART